# EUROPÄISCHE PATENTSCHRIFT

(11) **EP 3 187 031 B1**
(45) Veröffentlichungstag und Bekanntmachung des Hinweises auf die Patenterteilung: **10.10.2018**
(21) Anmeldenummer: 15752924.9
(22) Anmeldetag: 18.08.2015
(51) Int. Cl.: H05K 7/02, H05K 7/14, H05K 5/00

(54) **MODULARE BAUGRUPPE**
MODULAR ASSEMBLY
ENSEMBLE MODULAIRE

(30) Priorität: 28.08.2014 DE 102014012826
(43) Veröffentlichungstag der Anmeldung: 05.07.2017
(73) Patentinhaber: Diehl Aerospace GmbH, 88662 Überlingen (DE)
(72) Erfinder: SPÄH, Jürgen, 88662 Überlingen (DE)
(74) Vertreter: Diehl Patentabteilung
(86) Internationale Anmeldenummer: PCT/EP2015/001692
(87) Internationale Veröffentlichungsnummer: WO 2016/030005

(56) Entgegenhaltungen:
- GB-A- 2 298 452
- US-A- 6 104 611
- US-A1- 2002 044 420
- US-A1- 2006 285 289
- US-A1- 2012 243 181
- "Rigid assembly takes cannon-launch g", ELECTRONICS INT,, 18. August 1977 (1977-08-18), Seiten 50-52, XP001449923,

## Beschreibung

Die Erfindung betrifft eine modulare Baugruppe zur Aufnahme von Leiterplatten.

Aus der GB 2 298 452 A, US 6,104,611 A, US 2002/0044420 A1 sowie US 2006/285289 A122 sind allgemein Gehäuse zur Aufnahme von Leiterplatten bekannt.

Aufgabe der Erfindung ist es, eine modulare Baugruppe zur Aufnahme von Leiterplatten bereitzustellen, welche auf eine größere Anzahl von Leiterplatten erweitert werden kann.

Diese Aufgabe wird durch die Merkmale des Patentanspruchs 1 gelöst. Zweckmäßige Ausgestaltungen ergeben sich aus den Merkmalen der Ansprüche 2 bis 12.

Nach Maßgabe der Erfindung ist vorgesehen, dass die modulare Baugruppe zumindest zwei Gehäuseteile, in welchen jeweils eine Leiterplatte aufgenommen ist, zumindest ein internes Anschlussmittel, ein Deckelelement und ein Abschlusselement umfasst, wobei jedes Gehäuseteil aus einer Bodenplatte, einer Rück-wand und damit verbundenen Seitenwänden gebildet ist. Vorzugsweise ist jedes Gehäuseteil einstückig aus der Boden-platte, der Rückwand und den damit verbundenen Seitenwänden gebildet.

Nach Maßgabe der Erfindung ist weiterhin vorgesehen, dass die Gehäuseteile derart gestapelt sind, dass sich die Seitenwände zu einer ersten und einer zweiten Gesamtseitenwand ergänzen, und dass sich die Rückwände zu einer Gesamtrückwand ergänzen. Die erste, zweite Gesamtseitenwand und/oder die Gesamtrückwand weisen jeweils vor-zugsweise eine im Wesentlichen ebene Oberfläche auf. Die erste, zweite Gesamtseitenwand und/oder die Gesamtrückwand können aber auch insbesondere aufgrund her-vorstehender oder zurückgesetzter Bodenplatten eine oder mehrere Stufen und/oder eine oder mehrere Öffnungen umfassen.

Nach Maßgabe der Erfindung ist weiterhin vorgesehen, dass zumindest zwei der Gehäuseteile derart gestapelt sind, dass die Bodenplatte des einen Gehäuseteils mit den Seitenwänden des anderen Gehäuseteils verbunden ist. Vorzugsweise ist die Bodenplatte des einen Gehäuseteils auch an der Rückwand des anderen Gehäuseteils verbunden. Die Bodenplatte des einen Gehäuseteils kann an den Seitenwänden und/oder an der Rückwand des anderen Gehäuseteils anliegen. Die Bodenplatte des einen Gehäuseteils kann alternativ mittels Abstandshaltern mit den Seitenwänden und/oder mit der Rück-wand des anderen Gehäuseteils verbunden sein. Dazu können die Seitenwände und/oder die Rückwand des anderen Gehäuseteils Abstandshalter umfassen, welche jeweils mit einer an der Bodenplatte vorgesehenen Halterung verbunden sind.

Nach Maßgabe der Erfindung ist weiterhin vorgesehen, dass sich das zumindest eine interne Anschlussmittel in einer Richtung senkrecht zu den Bodenplatten erstreckt und mehrere Leiterplatten über erste Anschlüsse verbindet. Dazu können eine oder mehrere Leiterplatten und/oder eine oder mehrere Bodenplatten jeweils eine Ausnehmung zur Durchführung zumindest des einen internen Anschlussmittels aufweisen. Die Ausnehmungen liegen vorzugsweise in einer Flucht. Die Bodenplatten und/oder Leiterplatten können auch jeweils mehrere Ausnehmungen zur Durchführung mehrerer interner Anschlussmittel aufweisen. Es kann aber auch auf Ausnehmungen in den Bodenplatten und/oder in den Leiterplatten verzichtet werden, wenn das zumindest eine interne Anschlussmittel beispielsweise an einer der Gesamtrückwand gegenüberliegenden Vorder-seite an den Bodenplatten bzw. Leiterplatten vorbeigeführt ist. Das interne Anschlussmit-tel kann fest mit den Leiterplatten verbunden sein, beispielsweise mittels Lötkontakten, oder beispielsweise mittels Steckverbindungen lösbar mit den Leiterplatten verbunden sein. Beim internen Anschlussmittel kann es sich beispielsweise um ein Kabel, eine weitere Leiterplatte oder um eine optische Verbindung handeln. Die weitere Leiterplatte kann starr oder flexibel ausgestaltet sein. Die Verwendung einer mehrere Leiterplatten verbindenden weiteren Leiterplatte als internes Anschlussmittel ist besonders vorteilhaft, weil dadurch die Anzahl an erforderlichen Steckverbindungen reduziert wird. Dadurch können zusätzliche Übergangswiderstände bzw. Spannungsabfall vermieden werden.

Nach Maßgabe der Erfindung ist weiterhin vorgesehen, dass das Deckelelement an den Seitenwänden genau eines Gehäuseteils anliegt. Vorzugsweise liegt das Deckelelement auch an der Rückwand des genau einen Gehäuseteils an.

Nach Maßgabe der Erfindung ist weiterhin vorgesehen, dass das Abschlusselement an einer der Gesamtrückwand gegenüberliegenden Vorderseite an den Gehäuseteilen an-gebracht ist. Das Abschlusselement ist vorzugsweise eine die Vorderseite abdeckende Abschlussplatte. Die Abschlussplatte ist vorzugsweise aus Metall hergestellt. Auf der Abschlussplatte können Buchsen zum Anschließen von externen Geräten vorgesehen sein, wobei jede Buchse jeweils mit einer der Leiterplatten verbunden ist. Dadurch kann eine quaderförmige modulare Baugruppe bereitgestellt werden, deren sechs Seiten durch Umwandungen im Wesentlichen abgeschlossen sind.

Die modulare Baugruppe kann durch Hinzufügen weiterer Gehäuseteile einfach erweitert werden, um eine größere Anzahl von Leiterplatten aufnehmen zu können. Der modulare Aufbau macht die modulare Baugruppe besonders kostengünstig.

Nach Maßgabe der Erfindung ist weiterhin vorgesehen, dass das Abschlusselement ein Abschlussgehäuse ist. Das Abschlussgehäuse ist vorzugsweise aus Metall hergestellt. Das Abschlussgehäuse ist vorzugsweise selbst modular aufgebaut.

Nach Maßgabe der Erfindung ist weiterhin vorgesehen, dass an zumindest einer Leiterplatte eine Erweiterungsplatte angebracht ist, welche sich im Abschlussgehäuse befindet. Durch das Vorsehen des Abschlussgehäuses und durch die Verwendung von Erweiterungsplatten ist die modulare Baugruppe auf eine besonders einfache und schnelle Weise um neue Funktionen erweiterbar.

Nach Maßgabe der Erfindung ist weiterhin vorgesehen, dass zwischen der Leiterplatte und der Erweiterungsplatte eine Aussparung zur Durchführung zumindest eines der internen Anschlussmittel vorgesehen ist, wobei das zumindest eine der internen Anschlussmittel über erste Anschlüsse mit mehreren Leiterplatten oder mit mehreren Erweiterungsplatten oder mit sowohl zumindest einer Leiterplatte als auch zumindest einer Erweiterungsplatte verbunden ist. Zweckmäßigerweise fluchtet die Aussparung mit zumindest einer weiteren Aussparung und/oder zumindest einer in den weiteren Leiterplatten vorgesehenen Ausnehmung. Dadurch können auf eine einfache Weise Verbindungen zwischen mehreren in der modularen Baugruppe aufgenommenen Leiterplatten und/oder Ergänzungsplatten hergestellt werden.

Nach einer vorteilhaften Ausgestaltung ist vorgesehen, dass das Deckelelement eine Deckelplatte ist, welche im Wesentlichen parallel zu den Bodenplatten ist. Vorzugsweise liegt die Deckelplatte auch an der Rückwand des genau einen Gehäuseteils an. Weiterhin besteht die Deckelplatte vorzugsweise aus Metall.

Nach einer dazu alternativen vorteilhaften Ausgestaltung ist vorgesehen, dass das Deckelelement eines oder mehrere Gehäuseteile umfasst, und dass das genau eine Gehäuseteil und genau ein anderes Gehäuseteil, welches vom Deckelelement umfasst wird, derart gestapelt sind, dass die Seitenwände des genau einen Gehäuseteils an den Seitenwänden des anderen Gehäuseteils anliegen, ohne dass sich eine der Bodenplatten dieser beiden Gehäuseteile dazwischen befindet. Vorzugsweise liegt dabei auch die Rückwand des genau einen Gehäuseteils an der Rückwand des anderen Gehäuseteils an. Durch diese Art der Stapelung kann eine quaderförmige modulare Baugruppe mit sechs umwandeten Seiten bereitgestellt werden, ohne dass eine zu den Bodenplatten parallele Deckelplatte vorzusehen wäre.

Nach einer weiteren vorteilhaften Ausgestaltung ist vorgesehen, dass die im genau einen Gehäuseteil aufgenommene Leiterplatte und die im anderen Gehäuseteil aufgenommene Leiterplatte jeweils zumindest einen Prozessor aufweisen und mittels zumindest eines Prozessorverbindungsmittels direkt miteinander verbunden sind. Dazu ist vorzugsweise auf den beiden Leiterplatten jeweils ein Steckelement aufgelötet. Die beiden Steckelemente werden zur Ausbildung des Prozessorverbindungsmittels vorzugsweise direkt ineinandergesteckt. Zweckmäßigerweise befinden sich die Steckelemente jeweils in unmittelbarer Nachbarschaft zu einem der Prozessoren. Auf diese Weise ist es möglich, zwei prozessorverbundene Computer in einem Gehäuse zu betreiben. Es können auch beispielsweise zwei Steckelemente auf jeder der beiden Leiterplatten vorgesehen sein, die paarweise ineinanderzustecken sind.

Nach einer weiteren vorteilhaften Ausgestaltung ist vorgesehen, dass zumindest eine Bodenplatte mittels zumindest einer Heatpipe thermisch mit einer weiteren Bodenplatte verbunden ist. Vorzugsweise ist zumindest eine innenliegende Bodenplatte mittels zumindest einer Heatpipe thermisch mit einer weiter außen liegenden Bodenplatte, besonders bevorzugt mit einer eine äußere Oberfläche der modularen Baugruppe bildenden Bodenplatte, verbunden. Zusätzlich kann die innenliegenden Bodenplatte massive metallische Körper in unmittelbarer Nachbarschaft zu wärmeerzeugenden Bauelementen auf-weisen, welche sich auf benachbarten Leiterplatten befinden. Unter dem Begriff "benachbarte Leiterplatte" wird sowohl die vom die innenliegende Bodenplatte umfassenden Gehäuseteil aufgenommene Leiterplatte als auch die Leiterplatte verstanden, die sich auf der dazu anderen Seite der innenliegenden Bodenplatte befindet und von einem anderen Gehäuseteil aufgenommen ist. Die zuletzt genannte Leiterplatte hat also auf jeder ihrer beiden Seiten jeweils eine benachbarte Bodenplatte. Daher ist es möglich, von jeder der beiden Seiten dieser Leiterplatte Wärme an die jeweils benachbarte Bodenplatte abzuführen. Vorzugsweise erstrecken sich dazu jeweils massive metallische Körper von der jeweiligen Bodenplatte zu den wärmeerzeugenden Bauelementen auf der Leiterplatte hin. Vorzugsweise stehen die massiven metallischen Körper jeweils in direktem thermischem Kontakt mit einer Heatpipe. Das Vorsehen von massiven metallischen Körpern und/oder Heatpipes ermöglicht ein effektives Abführen von Wärme von der innenliegen-den Leiterplatte nach außen.

Nach einer weiteren vorteilhaften Ausgestaltung ist vorgesehen, dass die Seitenwände zumindest eines Gehäuseteils Öffnungen zur Ausbildung zumindest eines Lüftungskanals aufweisen. Durch den Lüftungskanal strömende Luft kann die vom Gehäuseteil auf-genommene Leiterplatte umströmen und damit Wärme von den auf ihr vorgesehenen Bauelementen abführen. Alternativ oder zusätzlich kann der Lüftungskanal auch so aus-gestaltet sein, dass die durch den Lüftungskanal strömende Luft eine der Leiterplatte benachbarte Bodenplatte umströmen oder lediglich die der Leiterplatte abgewandte oder zugewandte Oberfläche der benachbarten Bodenplatte entlangströmen kann. Dabei kann die der Leiterplatte abgewandte bzw. zugewandte Oberfläche der benachbarten Bodenplatte auch eine Noppenstruktur oder eine Rippenstruktur aufweisen. Dadurch weist die der Leiterplatte abgewandte bzw. zugewandte Oberfläche der benachbarten Bodenplatte eine größere effektive Oberfläche auf und kann damit besser Wärme abgeben. Die Lüftung kann aktiv oder passiv erfolgen. Insbesondere kann die Lüftung unter Ausnutzung des Kamineffekts erfolgen.

Zweckmäßigerweise sind die Gehäuseteile aus Metall hergestellt. Solche Gehäuseteile zeichnen sich durch eine gute Wärmeleitfähigkeit und eine gute Abschirmung von elektromagnetischen Feldern aus. Insbesondere können metallische Bodenplatten die verschiedenen Leiterplatten trennen und sie dabei gegenseitig voneinander abschirmen.

Nach einer weiteren vorteilhaften Ausgestaltung ist vorgesehen, dass zumindest eine Leiterplatte sich bis ins Abschlussgehäuse hinein erstreckt.

Nach einer weiteren vorteilhaften Ausgestaltung ist vorgesehen, dass an einer Außenseite des Abschlussgehäuses zweite Anschlüsse für externe Verbindungen vorgesehen sind. Bei den zweite Anschlüssen handelt es sich vorzugsweise um Steckelementen wie Einbaustecker und/oder Buchsen. Dadurch lassen sich besonders einfach externe Geräte und/oder eine Stromversorgung an die modulare Baugruppe anschließen.

Nach einer weiteren vorteilhaften Ausgestaltung ist vorgesehen, dass an einer Außenseite des Abschlussgehäuses dritte Anschlüsse für zumindest ein externes Anschlussmittel zwischen mehreren Leiterplatten oder mehreren Erweiterungsplatten oder sowohl zumindest einer Leiterplatte als auch zumindest einer Erweiterungsplatte vorgesehen sind. Bei den dritten Anschlüssen handelt es sich vorzugsweise um Steckplätze und/oder Stiftleisten. Dadurch können besonders einfach Verbindungen zwischen mehreren in der modularen Baugruppe aufgenommenen Leiterplatten und/oder Ergänzungsplatten hergestellt werden.

Nach einer weiteren vorteilhaften Ausgestaltung ist vorgesehen, dass die internen und/oder externen Anschlussmittel durch Kabel, weitere Leiterplatten und/oder optische Verbindungen realisiert sind. Die Kabel können über Steckverbindungen mit den Leiterplatten und/oder Erweiterungsplatten verbunden sein. Dazu können an den Kabeln Stecker und auf den Leiterplatten bzw. Erweiterungsplatten korrespondierende Buchsen vorgesehen sein. Insbesondere als internes Anschlussmittel vorgesehene Kabel können auch direkt auf den Leiterplatten und/oder Erweiterungsplatten aufgelötet sein.

Nach einer weiteren vorteilhaften Ausgestaltung ist vorgesehen, dass die internen und/oder externen Anschlussmittel Signale und/oder Strom übertragen. Mittels der Anschlussmittel können beispielsweise Wired-OR-Funktionen oder Signal-Routing-Funktionen bereitgestellt werden.

Vorzugsweise greifen die Gehäuseteile beim Stapeln formschlüssig ineinander ein. Die Gehäuseteile können dazu derart ausgestaltet sein, dass die Seitenwände und/oder die Rückwand des einen Gehäuseteils beim Stapeln in eine am anderen Gehäuseteil vorgesehene Abstufung formschlüssig eingreifen. Zusätzlich oder alternativ kann eine Abstufung an der eingreifenden Seitenwand und/oder an der eingreifenden Rückwand vorgesehen sein. Durch diese Maßnahmen ist ein stabileres Stapeln der Gehäuseteile möglich.

Weiterhin ist vorzugsweise jede Leiterplatte mittels zumindest einer Schraubverbindung am diese aufnehmenden Gehäuseteil befestigt. Die einzelnen Gehäuseteile sind vorzugsweise ebenfalls mittels zumindest einer Schraubverbindung aneinander befestigt.

Weiterhin können die Rückwände der Gehäuseteile jeweils ein derartiges Profil aufweisen, so dass die Gesamtrückwand der modularen Baugruppe und die Gesamtrückwand einer weiteren, um 180° bezüglich einer in Stapelrichtung verlaufenden Achse gedrehten modularen Baugruppe formschlüssig ineinandergreifen. Auf diese Weise kann eine doppelte Baugruppe gebildet werden. Zusätzlich oder alternativ zur Profilierung der Rück-wände können zur Bildung der doppelten Baugruppe Befestigungsmittel im Bereich der Rückwände vorgesehen sein.

Nachfolgend werden bevorzugte Ausführungsbeispiele der Erfindung anhand von Zeichnungen näher erläutert. Es zeigen:
- Fig. 1: eine perspektivische Ansicht einer ersten modularen Baugruppe,
- Fig. 2: eine perspektivische Ansicht einer zweiten modularen Baugruppe,
- Fig. 3: eine Explosionsansicht der zweiten modularen Baugruppe,
- Fig. 4A: eine schematische Draufsicht auf ein Gehäuseteil,
- Fig. 4B: eine schematische Schnittdarstellung durch das Gehäuseteil,
- Fig. 5A: eine schematische perspektivische Ansicht einer Abdeckung,
- Fig. 5B: eine schematischer Ausschnitt aus einem Gehäuseteil mit eingesetzter Abdeckung,
- Fig. 6: eine perspektivische Ansicht einer ein Abschlussgehäuse umfassenden dritten modularen Baugruppe,
- Fig. 7A-D: schematische Darstellungen der dritten modularen Baugruppe,
- Fig. 8: eine schematische perspektivische Ansicht in die dritte modulare Baugruppe hinein,
- Fig. 9A, B: eine perspektivische Seitenansicht sowie Seitenansicht einer ein Abschlussgehäuse umfassenden vierten modularen Baugruppe, und
- Fig. 10A-D: schematische Schnittdarstellungen mehrerer Ausführungsbeispiele.

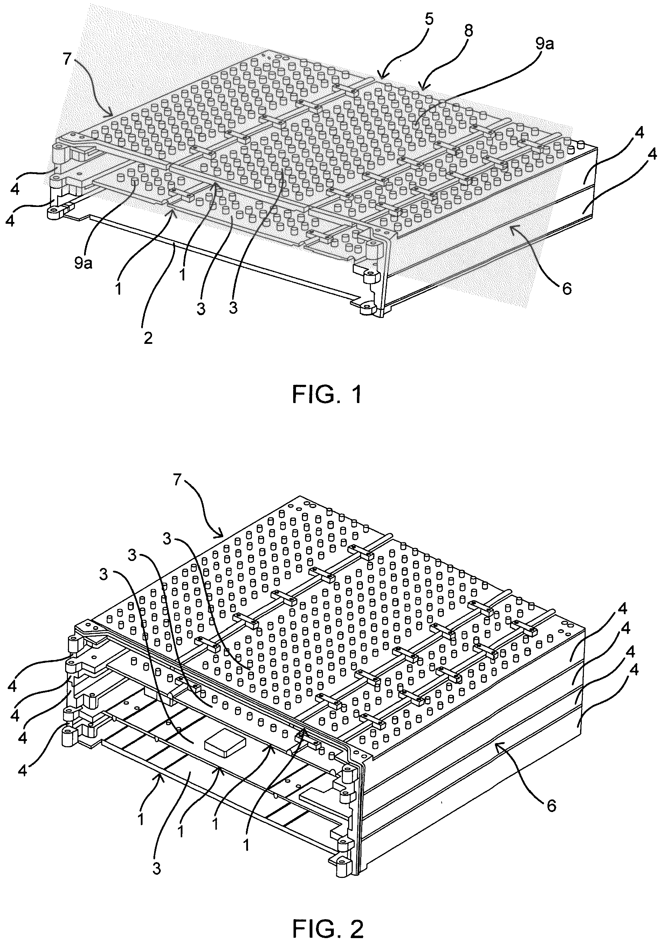

Fig. 1 zeigt eine perspektivische Ansicht einer ersten modularen Baugruppe, wobei hier die Leiterplatten weggelassen sind. Die erste modulare Baugruppe ist aus zwei Gehäuseteilen 1 und einer Deckelplatte 2 gebildet. Jedes der beiden Gehäuseteile 1 umfasst eine Bodenplatte 3, zwei Seitenwände 4 und eine Rückwand 5. Die Seitenwände 4 und die Rückwand 5 erstrecken sich jeweils ausgehend von der Bodenplatte 3 in Richtung der Deckelplatte 2. Die Rückwand 5 ist in der vorliegenden Ansicht verdeckt. Jedes der beiden Gehäuseteile 1 ist zur Aufnahme einer Leiterplatte bestimmt. Die beiden Gehäuseteile 1 sind in gleicher Ausrichtung zu einem Stapel aufeinander gestapelt. Die Seitenwände 4 bilden eine erste 6 und eine gegenüberliegende zweite Gesamtseitenwand 7. Die Rückwände 5 bilden eine (in der gegebenen Ansicht verdeckte) Gesamtrückwand 8. Die erste 6 und zweite Gesamtseitenwand 7 sowie die Gesamtrückwand 8 bilden jeweils eine im Wesentlichen ebene äußere Oberfläche. Der Stapel wird durch die Deckelplatte 2 abgeschlossen. Auf einer der Deckelplatte 2 abgewandten Außenseite der Bodenplatte 3 weist jedes der beiden Gehäuseteile 1 Noppen 9a auf. Als Außenseite einer Bodenplatte 3 wird allgemein jeweils die der aufgenommenen Leiterplatte abgewandte Seite verstanden. Als Innenseite einer Bodenplatte 3 wird entsprechend jeweils die der aufgenommenen Leiterplatte zugewandte Seite verstanden. Die Noppen 9a vergrößern die effektive Oberfläche und begünstigen daher die Wärmeabgabe.

Fig. 2 zeigt eine perspektivische Ansicht einer zweiten modularen Baugruppe, wobei die Leiterplatten hier wiederum weggelassen sind. Die zweite modulare Baugruppe ist aus vier Gehäuseteilen 1 gebildet. Jedes der vier Gehäuseteile 1 ist zur Aufnahme einer Leiterplatte bestimmt. Die zweite modulare Baugruppe umfasst keine Deckelplatte 2. Die Gehäuseteile 1 sind derart aufeinander gestapelt, dass die beiden oberen Gehäuseteile 1 in ihrer Ausrichtung übereinstimmen und auch die beiden unteren Gehäuseteile 1 in ihrer Ausrichtung übereinstimmen. Die beiden oberen Gehäuseteile 1 weisen jedoch gegenüber den beiden unteren Gehäuseteilen 1 eine entgegengesetzte Ausrichtung auf.

Dadurch ist zwischen den oberen und den unteren Gehäuseteilen 1 ein Raum zur Aufnahme von zwei Leiterplatten gebildet.

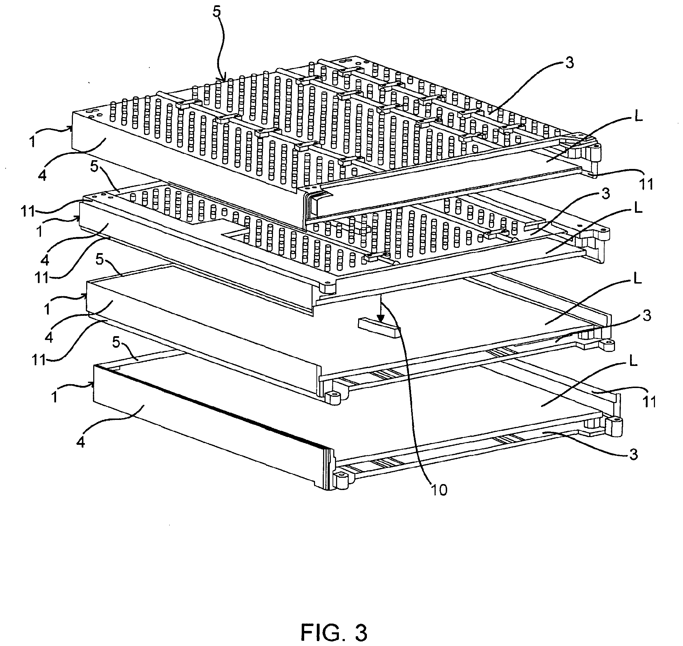

Fig. 3 zeigt eine Explosionsansicht der zweiten modularen Baugruppe. In Fig. 3 sind die Leiterplatten dargestellt und mit dem Bezugszeichen L versehen. Zwischen den beiden mittleren Leiterplatten L befindet sich keine Bodenplatte 3. Die beiden mittleren Leiterplatten L weisen auf ihren einander zugewandten Seiten jeweils einen Prozessor auf. Den beiden Prozessoren ist jeweils ein Steckelement zugeordnet. Wie durch den Pfeil angedeutet ist, sind die beiden Steckelemente zur Herstellung eines Prozessorverbindungsmittels 10 direkt ineinandergesteckt. Bei den beiden jeweils äußeren Leiterplatten L kann es sich um Schnittstellenkarten handeln. Bei der in Fig. 3 gezeigten Explosionsansicht ist außerdem zu erkennen, dass die Gehäuseteile 1 Abstufungen 11 in einem Randbereich der Bodenplatten 3 und/oder an einer Längskante der Seitenwände 4 aufweisen. Die Gehäuseteile 1 greifen beim Stapeln aufgrund der Abstufungen 11 formschlüssig ineinander. Durch Vorsehen der Abstufungen 11 ist ein stabileres Stapeln der Gehäuseteile 1 möglich.

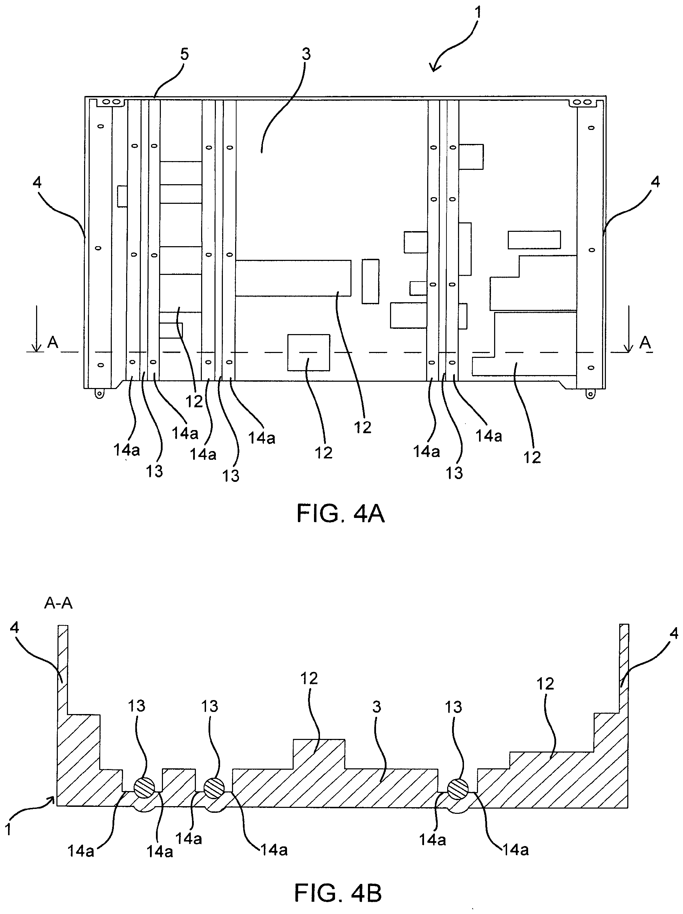

Fig. 4A zeigt eine schematische Draufsicht auf ein Gehäuseteil 1. Fig. 4B zeigt eine schematische Schnittdarstellung durch das Gehäuseteil nach Fig. 4A bezüglich der Schnittlinie A-A. Die vom Gehäuseteil 1 aufgenommene Leiterplatte L ist in den beiden Figuren nicht dargestellt. Auf der Innenseite der Bodenplatte 3 befinden sich mehrere massive metallische Körper 12 zur Aufnahme von Wärme von auf einer im Gehäuseteil 1 aufgenommenen Leiterplatte L vorgesehenen Bauelementen (nicht dargestellt). In drei länglichen Vertiefungen 14a auf der Innenseite der Bodenplatte 3 ist jeweils eine Heatpipe 13 angeordnet. Die drei Heatpipes 13 führen jeweils Wärme zu einer weiter außen liegenden Bodenplatte (nicht dargestellt) ab. Die massiven metallischen Körper 12 sind zweckmäßigerweise jeweils in Nachbarschaft zu einer der Heatpipes 13 angeordnet.

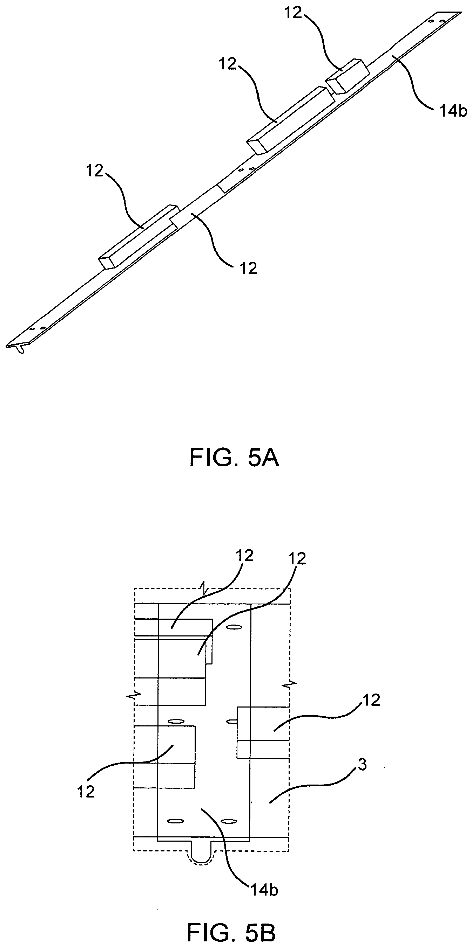

Fig. 5A zeigt eine perspektivische Ansicht einer Abdeckung 14b. Die Abdeckung 14b ist dazu ausgestaltet, in eine der in den Fig. 4A bzw. B dargestellten Vertiefungen 14a in die Bodenplatte 3 eingesetzt zu werden, und dabei die in der Vertiefung 14a aufgenommene Heatpipe 13 in der Bodenplatte 3 einzuschließen. Dadurch wird ein besonders guter thermischer Kontakt zwischen der Heatpipe 13 und der Bodenplatte 3 hergestellt. Fig. 5B zeigt einen schematischen Ausschnitt aus einem Gehäuseteil 1 mit eingesetzter Abdeckung 14b. Fig. 5B verwendet eine dreidimensionale Ansicht ohne perspektivische Verzerrung. Auch die Abdeckung 14b umfasst massive metallische Körper 12, welche sich mit den an der Innenseite der Bodenplatte 3 angeordneten massiven metallischen Körpern 12 ergänzen. Damit ist es möglich, massive metallische Körper 12 auch an Teile von Bauelementen heranzuführen, die sich in unmittelbarer Nachbarschaft zu der durch die Abdeckung 14b abgedeckten Heatpipe 13 befinden. Weiterhin stehen die massiven metallischen Körper 12 dadurch in einem unmittelbaren thermischen Kontakt mit der Heatpipe 13. Durch das Vorsehen einer solchen Abdeckung 14b kann also die Wärme besonders effektiv durch die Heatpipe 13 abgeführt werden.

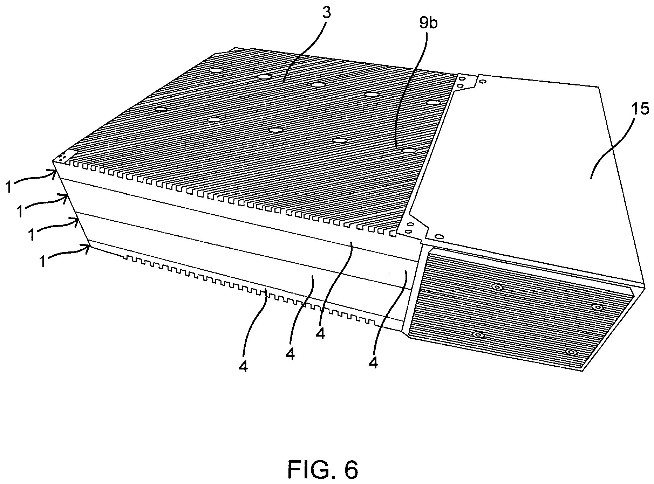

Fig. 6 zeigt eine perspektivische Ansicht einer ein Abschlussgehäuse 15 umfassenden dritten modularen Baugruppe. Das Abschlussgehäuse 15 ist an einer der Gesamtrückwand 8 gegenüberliegenden Vorderseite an den Gehäuseteilen 1 angebracht. Die dritte modulare Baugruppe unterscheidet sich von der zweiten modularen Baugruppe durch das damit verbundene Abschlussgehäuse 15. Weiterhin sind hier bei den außenliegenden Gehäuseteilen 1 anstatt von Noppen 9a Rippen 9b vorgesehen. Auch die Rippen 9b bewirken eine Vergrößerung der effektiven Oberfläche und verbessern dadurch die Wärmeabgabe an die Umgebung.

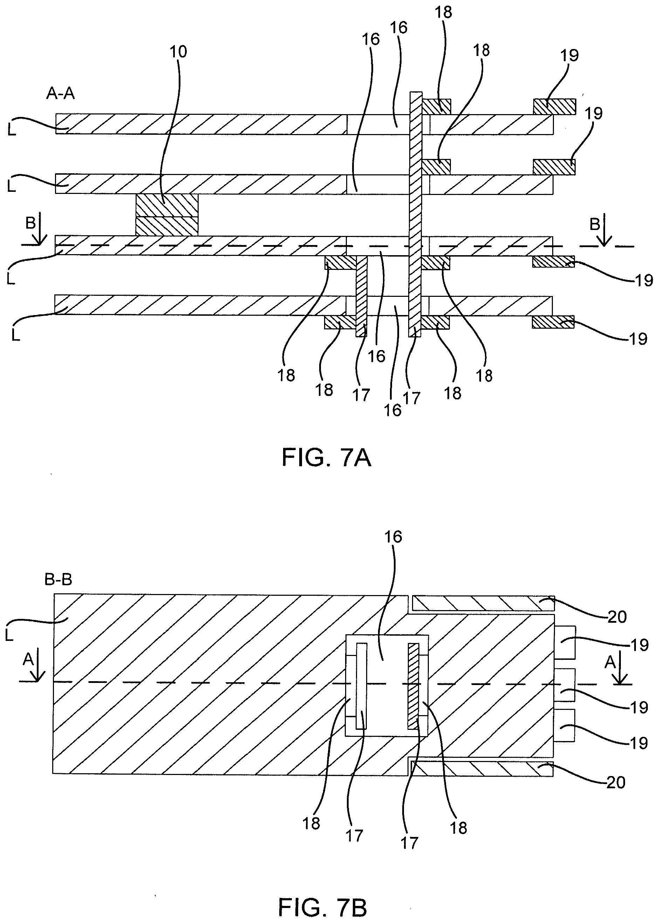

Fig. 7A-D zeigen schematische Darstellungen der dritten modularen Baugruppe. Die dritte modulare Baugruppe umfasst vier Gehäuseteile 1, die in der gleichen Art, wie die vier Gehäuseteile 1 der zweiten modularen Baugruppe gestapelt sind. Fig. 7A zeigt eine Schnittansicht bezüglich der in Fig. 7B ausgewiesenen Schnittlinie A-A. In Fig. 7A sind insbesondere die Leiterplatten L dargestellt. Nicht dargestellt sind beispielsweise die Gehäuseteile 1 und das Abschlussgehäuse 15. Die Leiterplatten L sind jeweils in einem Gehäuseteil 1 aufgenommen, erstrecken sich aber zusätzlich bis ins Abschlussgehäuse 15 hinein. Im Bereich des Abschlussgehäuses 15 bzw. in einem Übergangsbereich zwischen den Gehäuseteilen 1 und dem Abschlussgehäuse 15 weisen die Leiterplatten L Ausnehmungen 16 auf. Im Bereich der Ausnehmungen 16 sind zwei interne Anschlussmittel 17 vorgesehen, von denen eines eine Verbindung zwischen den unteren beiden Leiterplatten L herstellt und das andere eine Verbindung zwischen allen vier Leiterplatten L herstellt. Bei den beiden internen Anschlussmitteln 17 handelt es sich jeweils um eine in einer Querrichtung verlaufende weitere Leiterplatte. Die internen Anschlussmittel 17 sind mittels erster Anschlüsse 18 an den Leiterplatten L angeschlossen. Weiterhin ist zwischen den benachbarten mittleren Leiterplatten L ein Prozessorverbindungsmittel 10 für dort vorhandene Prozessoren (nicht dargestellt) vorgesehen. Dazu ist auf den beiden Leiterplatten L jeweils ein Steckelement in unmittelbarer Nachbarschaft zu einem der Prozessoren aufgelötet. Die beiden Steckelemente sind zur Ausbildung des Prozessorverbindungsmittels 10 direkt ineinandergesteckt. Die Leiterplatten L sind darüber hinaus mit zweiten Anschlüssen 19 verbunden. Bei den zweiten Anschlüssen 19 handelt es sich beispielsweise um Buchsen, welche an einer Außenseite des Abschlussgehäuses 15 zum Einstecken von Steckern verfügbar sind. Die zweiten Anschlüsse 19 befinden dabei sich beispielsweise an einer der Gesamtrückwand 8 gegenüberliegenden Vorderwand des Abschlussgehäuses 15. Mittels der zweiten Anschlüssen 19 können externe Geräte und/oder eine Stromversorgung angeschlossen werden.

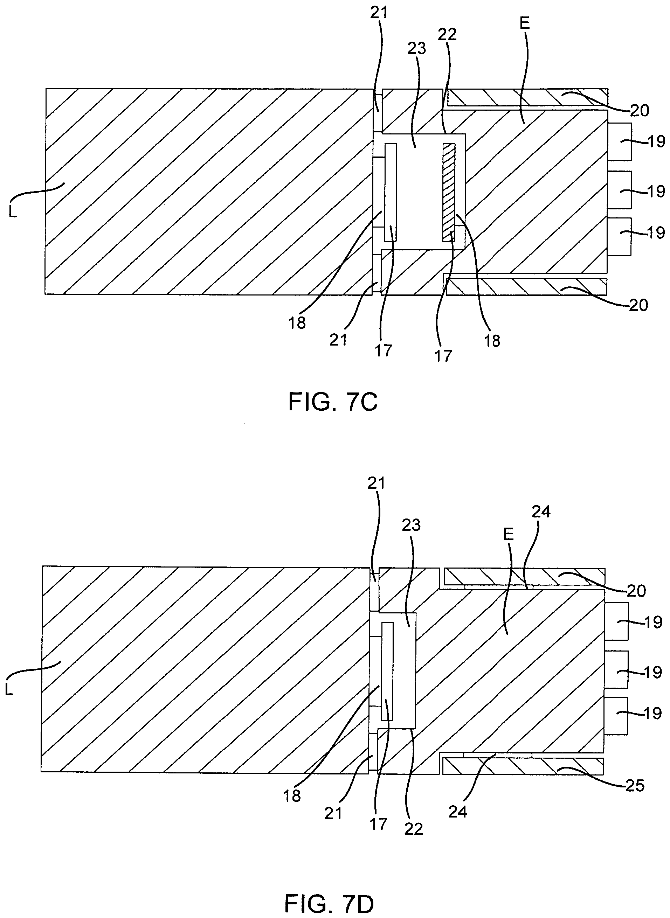

Die Fig. 7B, 7C und 7D zeigen verschiedene Ausgestaltungsmöglichkeiten einer in der dritten modularen Baugruppe vorgesehenen Leiterplatte L. Die Fig. 7B zeigt eine Leiterplatte L in Schnittansicht bezüglich der in Fig. 7A ausgewiesenen Schnittlinie B-B. Die in Fig. 7B dargestellte Leiterplatte L ist jeweils mittels eines ersten Anschlusses 18 an jedes der beiden internen Anschlussmittel 17 angeschlossen. Lediglich eines der beiden internen Anschlussmittel 17 greift dabei innerhalb der Ausnehmung 16 durch die Leiterplatte L hindurch. Das Bezugszeichen 20 bezeichnet eine Stromversorgungseinheit, welche beidseitig im Abschlussgehäuse 15 aufgenommen ist. Die Leiterplatte L weist in diesem Bereich eine Verengung auf. Die Leiterplatte L ist über eine nicht dargestellte Kabelverbindung an die Stromversorgungseinheit 20 angeschlossen. Der innerhalb des Abschlussgehäuses 15 gelegene Abschnitt der Leiterplatte L weist Überspannungsschutzmittel auf.

Fig. 7C zeigt eine Leiterplatte L, an welcher über zwei Steckverbindungen 21 eine Erweiterungsplatte E angebracht ist. Die Leiterplatte L befindet sich im Bereich der Gehäuseteile 1. Die Erweiterungsplatte E befindet sich im Bereich des Abschlussgehäuses 15. Die Anordnung aus Leiterplatte und Erweiterungsplatte E kann anstatt der in Fig. 7B dargestellten Leiterplatte L in der dritten modularen Baugruppe vorgesehen sein. Die Erweiterungsplatte E weist eine Einbuchtung 22 zur Leiterplatte L hin auf, so dass eine Aussparung 23 zwischen der Erweiterungsplatte E und der Leiterplatte L gebildet ist. Eines der beiden internen Anschlussmittel 17 ist über einen ersten Anschluss 18 an die Leiterplatte L angeschlossen. Das andere der beiden internen Anschlussmittel 17 ist über einen ersten Anschluss 18 an die Erweiterungsplatte E angeschlossen. Lediglich das an die Erweiterungsplatte E angeschlossene interne Anschlussmittel 17 greift durch die Aussparung 23 zwischen der Leiterplatte L und der Erweiterungsplatte E hindurch. Eine Stromversorgungseinheit 20 ist beidseitig im Abschlussgehäuse 15 aufgenommen. Die Erweiterungsplatte E weist dazu eine entsprechende Verengung auf und ist über eine nicht dargestellte Kabelverbindung an die Stromversorgungseinheit 20 angeschlossen. Die Erweiterungsplatte E weist Überspannungsschutzmittel auf. Die Leiterplatte L kann eine oder mehrere Schnittstellen und/oder einen oder mehrere Prozessoren umfassen.

Fig. 7D zeigt wie bereits Fig. 7C eine Leiterplatte L, an welcher über zwei Steckverbindungen 21 eine Erweiterungsplatte E angebracht ist. Abweichend von der Ausgestaltung nach Fig. 7C ist die Erweiterungsplatte E nicht an ein internes Anschlussmittel 17 angeschlossen. Stattdessen weist die in Fig. 7D dargestellte Erweiterungsplatte E zwei dritte Anschlüsse 24 auf, welche in Form von Steckplätzen bzw. Steckleisten an eine Außenseite des Abschlussgehäuses 15 führen. Über einen der dritten Anschlüsse 24 ist ein externes Anschlussmittel 25 an die Erweiterungsplatte E angeschlossen. Das externe Anschlussmittel 25 verbindet die Erweiterungsplatte E mit zumindest einer weiteren Erweiterungsplatte E und/oder zumindest einer Leiterplatte L. Über den anderen der beiden dritten Anschlüsse 24 ist die Stromversorgungseinheit 20 an die Erweiterungsplatte E angeschlossen. Die Erweiterungsplatte E weist Überspannungsschutzmittel auf. Die Leiterplatte L kann eine oder mehrere Schnittstellen und/oder einen oder mehrere Prozessoren umfassen.

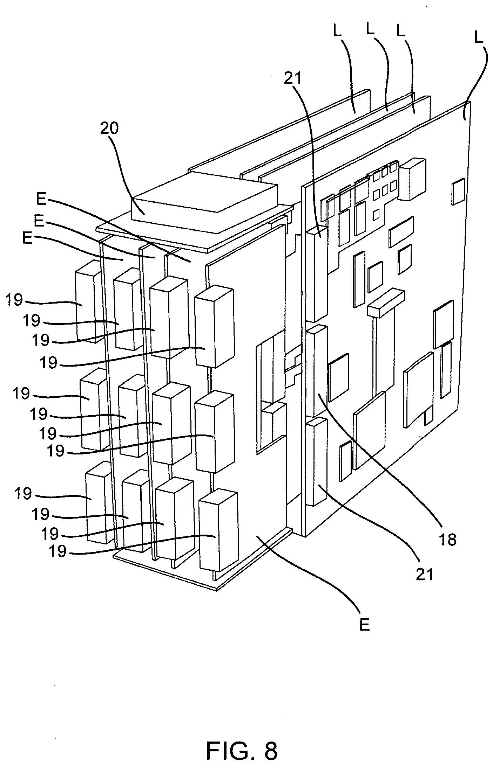

Fig. 8 zeigt eine schematische perspektivische Ansicht in die dritte modulare Baugruppe hinein. Dazu sind insbesondere die Gehäuseteile 1 und das Abschlussgehäuse 15 nicht dargestellt.

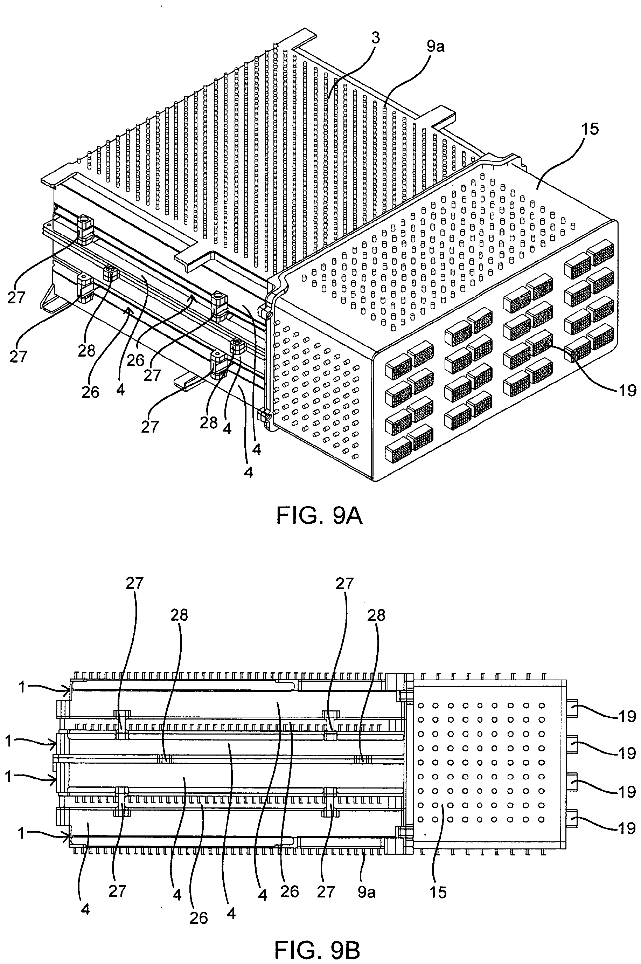

Fig. 9A zeigt eine perspektivische Seitenansicht einer vierten modularen Baugruppe. Die vierte modulare Baugruppe umfasst ein Abschlussgehäuse 15 und vier Gehäuseteile 1, die in der gleichen Art, wie die vier Gehäuseteile 1 der zweiten und der dritten modularen Baugruppe gestapelt sind. Fig. 9B zeigt eine Seitenansicht der vierten modularen Baugruppe. An einer der Gesamtrückwand 8 gegenüberliegende Vorderwand des Abschlussgehäuses 15 sind mit den Leiterplatten L verbundene zweite Anschlüsse 19, beispielsweise Buchsen, vorgesehen. Im dargestellten Beispiel sind dabei jeder Leiterplatte L jeweils vier Doppelbuchsen zugeordnet. Die Seitenwände 4 der beiden außenliegenden Gehäuseteile 1 weisen jeweils eine Öffnung 26 auf. Durch Vorsehen der Öffnungen 26 wird durch die beiden außenliegenden Gehäuseteile 1 jeweils ein Lüftungskanal ausgebildet. Luft kann durch einen solchen Luftkanal entlang der äußeren Oberfläche der Bodenplatte 3 eines der innenliegenden Gehäuseteile 1 strömen. Dadurch kann von einer der innenliegenden Leiterplatten L an die Bodenplatte 3 des innenliegenden Gehäuseteils 1 abgegebene Wärme abgeführt werden. Die äußere Oberfläche der Boden- platten 3 weist eine Vielzahl von Noppen 9a auf. Durch Vorsehen der Noppen erhöht sich die Kontaktoberfläche zwischen Luft und Bodenplatte 3. Dadurch wird eine besonders gute Wärmeübertragung von den Bodenplatten 3 zur Luft erreicht. Damit die Stabilität der modularen Baugruppe trotz des Vorsehens der Öffnungen 29 nicht geschwächt ist, sind bei der vierten modularen Baugruppe besonders breite mechanische Verbindungen der Gehäuseteile 1 vorgesehen. Beispielsweise ist das außenliegende Gehäuseteil 1 über mehrere Abstandshalter 27 jeweils am innenliegenden Gehäuseteil 1 befestigt. Die Abstandshalter 27 erstrecken sich dazu von den Seitenwänden 4 des außenliegenden Gehäuseteils 1 und sind an einer an der Bodenplatte 3 des innenliegenden Gehäuseteils 1 vorgesehenen Halterung mit einem Befestigungsmittel, beispielsweise einer Schraube, befestigt. Weitere Abstandshalter können auch an der Rückwand 5 des außenliegenden Gehäuseteils 1 vorgesehen sein. An den Seitenwänden 4 der beiden innenliegenden Gehäuseteile 1 sind außerdem jeweils zueinander korrespondierend angeordnete Verbindungsmittel 28 angebracht. Die beiden innenliegenden Gehäuseteile 1 können mittels der Verbindungsmittel 28 fest miteinander verbunden werden. Die Verbindungsmittel 28 können dazu beispielsweise jeweils mit einer Schraube fest verbunden werden. Das dargestellte Ausführungsbeispiel basiert auf einer passiven Kühlung und umfasst dementsprechend keine zusätzliche Lüftervorrichtung. Zweckmäßigerweise ist die vierte modulare Baugruppe so ausgerichtet, dass die Lüftungskanäle sich in einer vertikalen Richtung erstrecken. In einer solchen Ausrichtung unterstützt der Kamineffekt die Belüftung. Durch das Vorsehen der Lüftungskanäle kann bei der vierten modularen Baugruppe auf Heatpipes 13 verzichtet werden.

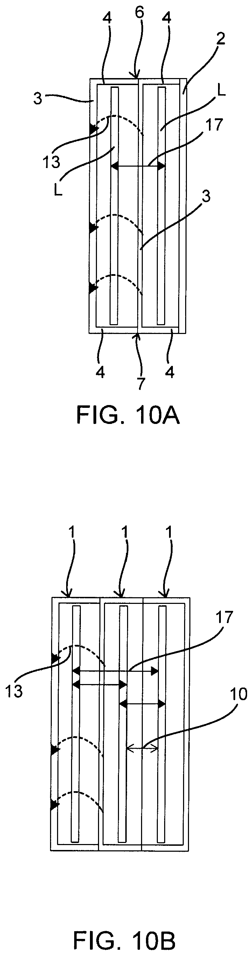

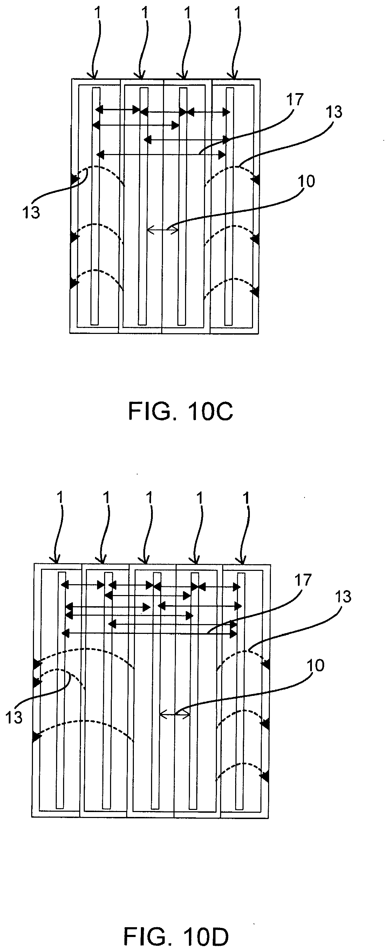

Fig. 10 zeigt schematische Schnittdarstellungen mehrerer erfindungsgemäßer Ausführungsbeispiele. Fig. 10A zeigt eine schematische Darstellung der ersten modularen Baugruppe. Zwei Gehäuseteile 1 sind in gleicher Ausrichtung zu einem Stapel aufeinander gestapelt. Eine zu den Bodenplatten 3 parallele Deckelplatte 2 schließt den Stapel ab. In den beiden Gehäuseteilen 1 ist jeweils eine Leiterplatte L aufgenommen. Die beiden Leiterplatten L sind mittels eines internen Anschlussmittels 17 miteinander verbunden. Die Seitenwände 4 bilden eine erste 6 und eine zweite Gesamtseitenwand 7. Drei Heatpipes 13 führen von der innenliegenden Bodenplatte 3 zur außenliegenden Bodenplatte 3.

Fig. 10B zeigt eine schematische Darstellung einer fünften modularen Baugruppe. Bei der fünften modularen Baugruppe ist die Deckelplatte 2 der ersten modularen Baugruppe durch ein weiteres Gehäuseteil 1 ersetzt, welches auf den beiden Gehäuseteilen 1 der ersten modularen Baugruppe in verglichen mit diesen entgegengesetzter Ausrichtung gestapelt ist. Im weiteren Gehäuseteil 1 ist eine weitere Leiterplatte L aufgenommen. Die weitere Leiterplatte L ist mittels des internen Anschlussmittels 17 und/oder mittels eines oder mehrerer weiterer interner Anschlussmittel 17 mit den beiden bereits in der ersten modularen Baugruppe vorgesehenen Leiterplatten L verbunden. Zusätzlich ist ein auf der weiteren Leiterplatte L vorgesehener Prozessor über ein Prozessorverbindungsmittel 10 mit einem auf der dieser unmittelbar zugewandten Leiterplatte L vorgesehenen Prozessor verbunden.

Fig. 10C zeigt eine schematische Darstellung der zweiten und dritten modularen Baugruppe. Die zweite und dritte modularen Baugruppe weist zusätzlich zu der in Fig. 10B dargestellten fünften modularen Baugruppe ein viertes Gehäuseteil 1 auf, welches auf dem weiteren Gehäuseteil 1 der fünften modularen Baugruppe in mit diesem übereinstimmender Ausrichtung gestapelt ist. Drei weitere Heatpipes 13 führen von der vom weiteren Gehäuseteil 1 umfassten Bodenplatte 3 zur Bodenplatte 3 des vierten Gehäuseteils 1. Die im vierten Gehäuseteil 1 aufgenommene Leiterplatte L ist mittels des internen Anschlussmittels 17 und/oder mittels eines oder mehrerer weiterer interner Anschlussmittel 17 mit den bereits in der fünften modularen Baugruppe vorgesehenen Leiterplatten L verbunden. Die vierte modulare Baugruppe weist im Unterschied zu Fig. 10C keine Heatpipes auf.

Fig. 10D zeigt eine schematische Darstellung einer sechsten modularen Baugruppe. Zusätzlich zu den in Fig. 10C dargestellten Ausführungsbeispielen weist die sechste modulare Baugruppe ein zusätzliches außenliegendes Gehäuseteil 1 auf, welches auf einem der in Fig. 10C außenliegenden Gehäuseteile 1 in mit diesem übereinstimmender Ausrichtung gestapelt ist. Von den Bodenplatten 3 der beiden weiter innen liegenden Gehäuseteile 1 sind jeweils zwei Heatpipes 13 zum zusätzlichen außenliegenden Gehäuseteil 1 geführt. Stattdessen sind keine Heatpipes 13 zwischen den Bodenplatten 3 der beiden weiter innen liegenden Gehäuseteile 1 vorgesehen. Die im zusätzlichen außenliegenden Gehäuseteil 1 aufgenommene Leiterplatte L ist mittels des internen Anschlussmittels 17 und/oder mittels eines oder mehrerer weiterer interner Anschlussmittel 17 mit den bereits in den in Fig. 10C dargestellten Ausführungsbeispielen vorgesehenen Leiterplatten L verbunden.

Aus den Fig. 10B bis 10D wird deutlich, dass eine erfindungsgemäße modulare Baugruppe um ein oder mehrere Gehäuseteile 1 erweitert werden kann. Die Erfindung umfasst daher insbesondere auch sich nach dem Aufbauprinzip der Fig. 10B bis 10D ergebende modulare Baugruppen mit sechs, sieben oder mehr Gehäuseteilen 1.

### BEZUGSZEICHENLISTE

- 1: Gehäuseteil
- 2: Deckelplatte
- 3: Bodenplatte
- 4: Seitenwände
- 5: Rückwand
- 6: erste Gesamtseitenwand
- 7: zweite Gesamtseitenwand
- 8: Gesamtrückwand
- 9a: Noppen
- 9b: Rippen
- 10: Prozessorverbindungsmittel
- 11: Abstufung
- 12: massive metallische Körper
- 13: Heatpipe
- 14a: Vertiefung
- 14b: Abdeckung
- 15: Abschlussgehäuse
- 16: Ausnehmung
- 17: internes Anschlussmittel
- 18: erster Anschluss
- 19: zweiter Anschluss
- 20: Stromversorgungseinheit
- 21: Steckverbindung
- 22: Einbuchtung
- 23: Aussparung
- 24: dritter Anschluss
- 25: externes Anschlussmittel
- 26: Öffnung
- 27: Abstandshalter
- 28: Verbindungsmittel

- L: Leiterplatte
- E: Erweiterungsplatte

## Patentansprüche

1. Modulare Baugruppe, umfassend
zumindest zwei Gehäuseteile (1), in welchen jeweils eine Leiterplatte (L) aufgenommen ist,
zumindest ein internes Anschlussmittel (17),
ein Deckelelement und
ein Abschlusselement,
wobei jedes Gehäuseteil (1) aus einer Bodenplatte (3), einer Rückwand (5) und damit verbundenen Seitenwänden (4) gebildet ist,
wobei die Gehäuseteile (1) derart gestapelt sind, dass sich die Seitenwände (4) zu einer ersten (6) und einer zweiten Gesamtseitenwand (7) ergänzen, und dass sich die Rück-wände (5) zu einer Gesamtrückwand (8) ergänzen,
wobei zumindest zwei der Gehäuseteile (1) derart gestapelt sind, dass die Bodenplatte (3) des einen Gehäuseteils (1) mit den Seitenwänden (4) des anderen Gehäuseteils (1) verbunden ist,
wobei sich das zumindest eine interne Anschlussmittel (17) in einer Richtung senkrecht zu den Bodenplatten (3) erstreckt und mehrere Leiterplatten (L) über erste Anschlüsse (18) verbindet,
wobei das Deckelelement an den Seitenwänden (4) genau eines Gehäuseteils (1) anliegt, **dadurch gekennzeichnet, dass** das Abschlusselement an einer der Gesamtrückwand (8) gegenüberliegenden Vorderseite an den Gehäuseteilen (1) angebracht ist,
wobei das Abschlusselement ein Abschlussgehäuse (15) ist,
wobei an zumindest einer Leiterplatte (L) eine Erweiterungsplatte (E) angebracht ist, welche sich im Abschlussgehäuse befindet,
wobei zwischen der Leiterplatte (L) und der Erweiterungsplatte (E) eine Aussparung (22) zur Durchführung zumindest eines der internen Anschlussmittel (17) vorgesehen ist, wobei das zumindest eine der internen Anschlussmittel (17) über erste Anschlüsse (18) mit mehreren Leiterplatten (L) oder mit mehreren Erweiterungsplatten (E) oder mit sowohl zumindest einer Leiterplatte (L) als auch zumindest einer Erweiterungsplatte (E) verbunden ist.

2. Modulare Baugruppe nach Patentanspruch 1, wobei das Deckelelement eine Deckelplatte (2) ist, welche im Wesentlichen parallel zu den Bodenplatten (3) ist.

3. Modulare Baugruppe nach Patentanspruch 1, wobei das Deckelelement eines oder mehrere Gehäuseteile (1) umfasst, und wobei das genau eine Gehäuseteil (1) und genau ein anderes Gehäuseteil (1), welches vom Deckelelement umfasst wird, derart gestapelt sind, dass die Seitenwände (4) des genau einen Gehäuseteils (1) an den Seitenwänden (4) des anderen Gehäuseteils (1) anliegen, ohne dass sich eine der Boden-platten (3) dieser beiden Gehäuseteile (1) dazwischen befindet.

4. Modulare Baugruppe nach Patentanspruch 3, wobei die im genau einen Gehäuseteil (1) aufgenommene Leiterplatte (L) und die im anderen Gehäuseteil (1) aufgenommene Leiterplatte (L) jeweils zumindest einen Prozessor aufweisen und mittels zumindest eines Prozessorverbindungsmittels (10) direkt miteinander verbunden sind.

5. Modulare Baugruppe nach einem der vorangehenden Patentansprüche, wobei zumindest eine Bodenplatte (3) mittels zumindest einer Heatpipe (13) thermisch mit einer weiteren Bodenplatte (3) verbunden ist.

6. Modulare Baugruppe nach einem der vorangehenden Patentansprüche, wobei die Seitenwände (4) zumindest eines Gehäuseteils (1) Öffnungen (26) zur Ausbildung zumindest eines Lüftungskanals aufweisen.

7. Modulare Baugruppe nach einem der vorangehenden Patentansprüche, wobei die Gehäuseteile (1) aus Metall hergestellt sind.

8. Modulare Baugruppe nach einem der vorangehenden Patentansprüche, wobei zumindest eine Leiterplatte (L) sich bis ins Abschlussgehäuse (15) hinein erstreckt.

9. Modulare Baugruppe nach einem der vorangehenden Patentansprüche, wobei an einer Außenseite des Abschlussgehäuses (15) zweite Anschlüsse (19) für externe Verbindungen vorgesehen sind.

10. Modulare Baugruppe nach einem der vorangehenden Patentansprüche, wobei an einer Außenseite des Abschlussgehäuses (15) dritte Anschlüsse (24) für zumindest ein externes Anschlussmittel (25) zwischen mehreren Leiterplatten (L) oder mehreren Erweiterungsplatten (E) oder sowohl zumindest einer Leiterplatte (L) als auch zumindest einer Erweiterungsplatte (E) vorgesehen sind.

11. Modulare Baugruppe nach Patentanspruch 10, wobei die internen (17) und/oder externen Anschlussmittel (25) durch Kabel, weitere Leiterplatten und/oder optische Verbindungen realisiert sind.

12. Modulare Baugruppe nach Patentanspruch 10 oder 11, wobei die internen (17) und/oder externen Anschlussmittel (25) Signale und/oder Strom übertragen.

## Claims

1. Modular assembly, comprising
at least two housing parts (1) in which in each case a circuit board (L) is received,
at least one internal connecting means (17),
a cover element and
a closing element,
wherein each housing part (1) is formed from a base plate (3), a rear wall (5) and side walls (4) that are connected to said rear wall,
wherein the housing parts (1) are stacked in such a manner that the side walls (4) combine to form a first (6) and a second complete side wall (7) and that the rear walls (5) combine to form a complete rear wall (8),
wherein at least two of the housing parts (1) are stacked in such a manner that the base plate (3) of the one housing part (1) is connected to the side walls (4) of the other housing part (1),
wherein the at least one internal connecting means (17) extends in a direction perpendicular to the base plates (3) and connects multiple circuit boards (L) by way of first connectors (18),
wherein the cover element lies on the side walls (4) precisely of a housing part (1), **characterized in that** the closing element is attached to a front side of the housing parts (1), said front side lying opposite the complete rear wall (8), wherein at least one circuit board (L) extends into the closing housing (15), wherein an expansion plate (E) is attached to at least one circuit board (L), said expansion plate being located in the closing housing, wherein a recess (22) is provided between the circuit board (L) and the expansion plate (E) for feeding through at least one of the internal connecting means (17), wherein the at least one of the internal connecting means (17) is connected by way of first connectors (18) to multiple circuit boards (L) or to multiple expansion plates (E) or to both at least one circuit board (L) as well as at least one expansion plate (E) .

2. Modular assembly according to Claim 1, wherein the cover element is a cover plate (2) that is essentially parallel to the base plates (3).

3. Modular assembly according to Claim 1, wherein the cover element comprises one or multiple housing parts (1), and wherein the precisely one housing part (1) and precisely one other housing part (1) that is encompassed by the cover element are stacked in such a manner that the side walls (4) of the precisely one housing part (1) lie on the side walls (4) of the other housing part (1) without one of the base plates (3) of these two housing parts (1) being located between said housing parts.

4. Modular assembly according to Claim 3, wherein the circuit board (L) that is received in the precisely one housing part (1) and the circuit board (L) that is received in the other housing part (1) in each case comprise at least one processor and are connected directly to one another by means of at least one processor connecting means (10).

5. Modular assembly according to any one of the preceding claims, wherein at least one base plate (3) is thermally connected by means of at least one heat pipe (13) to a further base plate (3).

6. Modular assembly according to any one of the preceding claims, wherein the side walls (4) of at least one housing part (1) comprise openings (26) for forming at least one ventilating duct.

7. Modular assembly according to any one of the preceding claims, wherein the housing parts (1) are produced from metal.

8. Modular assembly according to any one of the preceding claims, wherein the closing element is a closing housing (15).

9. Modular assembly according to any one of the preceding claims, wherein second connectors (19) are provided for external connections on an outer side of the closing housing (15).

10. Modular assembly according to any one of the preceding claims, wherein third connectors (24) are provided on an outer side of the closing housing (15) for at least one external connecting means (25) between multiple circuit boards (L) or multiple expansion plates (E) or both at least one circuit board (L) as well as at least one expansion plate (E).

11. Modular assembly according to Claim 10, wherein the internal (17) and/or external connecting means (25) are achieved by means of cables, further circuit boards and/or optical connections.

12. Modular assembly according to Claim 10 or 11, wherein the internal (17) and/or external connecting means (25) transfer signals and/or current.

## Revendications

1. Sous-ensemble modulaire, comprenant
au moins deux parties de boîtier (1) dans lesquelles est respectivement logé un circuit imprimé (L),
au moins un moyen de raccordement interne (17),
un élément formant couvercle et
un élément de fermeture,
chaque partie de boîtier (1) étant formée par une plaque de fond (3), une paroi arrière (5) et des parois latérales (4) reliées à celles-ci,
les parties de boîtier (1) étant empilées de telle sorte que les parois latérales se complètent pour former une première (6) et une deuxième paroi latérale totale (7), et les parois arrière (5) se complétant pour former une paroi arrière totale (8),
au moins deux des parties de boîtier (1) étant empilées de telle sorte que la plaque de fond (3) d'une partie de boîtier (1) est reliée aux parois latérales (4) de l'autre partie de boîtier (1),
l'au moins un moyen de raccordement interne (17) s'étendant dans une direction perpendiculaire aux plaques de fond (3) et reliant plusieurs circuits imprimés (L) par le biais de premières bornes (18),
l'élément formant couvercle reposant contre les parois latérales (5) d'exactement une partie de boîtier (1), **caractérisé en ce que**
l'élément de fermeture est monté sur un côté avant opposé à la paroi arrière totale (8) sur les parties de boîtier (1),
l'élément de fermeture étant un boîtier de fermeture (15),
une carte d'extension (E) étant montée sur au moins un circuit imprimé (L), laquelle se trouve dans le boîtier de fermeture,
une cavité (22) servant au passage d'au moins l'un des moyens de raccordement interne (17) se trouvant entre le circuit imprimé (L) et la carte d'extension (E), l'au moins un moyen de raccordement interne (17) étant relié, par le biais de premières bornes (18), à plusieurs circuits imprimés (L) ou à plusieurs cartes d'extension (E) ou à la fois à au moins un circuit imprimé (L) et au moins une carte d'extension (E).

2. Sous-ensemble modulaire selon la revendication 1, l'élément formant couvercle étant une plaque de couvercle (2) qui est sensiblement parallèle aux plaques de fond (3).

3. Sous-ensemble modulaire selon la revendication 1, l'élément formant couvercle comportant une ou plusieurs parties de boîtier (1), et l'exactement une partie de boîtier (1) et exactement une autre partie de boîtier (1) qui sont comprises par l'élément formant couvercle étant empilées de telle sorte que les parois latérales (4) de l'exactement une partie de boîtier (1) reposent contre les parois latérales (4) de l'autre partie de boîtier (1) sans que l'une des plaques de fond (3) de ces deux parties de boîtier (1) se trouve entre elles.

4. Sous-ensemble modulaire selon la revendication 3, le circuit imprimé (L) logé dans l'exactement une partie de boîtier (1) et le circuit imprimé (L) logé dans l'autre partie de boîtier (1) possédant respectivement au moins un processeur et étant reliés directement l'un à l'autre au moyen d'au moins un moyen de connexion de processeur (10).

5. Sous-ensemble modulaire selon l'une des revendications précédentes, au moins une plaque de fond (3) étant reliée thermiquement à une autre plaque de fond (3) au moyen d'au moins un caloduc (13).

6. Sous-ensemble modulaire selon l'une des revendications précédentes, les parois latérales (4) d'au moins une partie de boîtier (1) possédant des ouvertures (26) servant à former au moins un canal de ventilation.

7. Sous-ensemble modulaire selon l'une des revendications précédentes, les parties de boîtier (1) étant fabriquées en métal.

8. Sous-ensemble modulaire selon l'une des revendications précédentes, au moins un circuit imprimé (L) s'étendant jusqu'à l'intérieur du boîtier de fermeture (15).

9. Sous-ensemble modulaire selon l'une des revendications précédentes, des deuxièmes bornes (19) pour des connexions externes se trouvant sur un côté extérieur du boîtier de fermeture (15).

10. Sous-ensemble modulaire selon l'une des revendications précédentes, des troisièmes bornes (24) pour au moins un moyen de raccordement externe (25) entre plusieurs circuits imprimés (L) ou plusieurs cartes d'extension (E) ou à la fois au moins un circuit imprimé (L) et au moins une carte d'extension (E) se trouvant sur un côté extérieur du boîtier de fermeture (15).

11. Sous-ensemble modulaire selon la revendication 10, les moyens de raccordement internes (17) et/ou externes (25) étant réalisés par des câbles, des circuits imprimés supplémentaires et/ou des liaisons optiques.

12. Sous-ensemble modulaire selon la revendication 10 ou 11, les moyens de raccordement internes (17) et/ou externes (25) transmettant des signaux et/ou du courant.
